# EUROPÄISCHE PATENTSCHRIFT

(11) **EP 0 881 501 B1**
(45) Veröffentlichungstag und Bekanntmachung des Hinweises auf die Patenterteilung: **09.11.2005**
(21) Anmeldenummer: 98106398.5
(22) Anmeldetag: 08.04.1998
(51) Int. Cl.: G01R 31/00

(54) **Vorrichtung zur Funktionsüberprüfung eines elektronisch gesteuerten Regelsystems in einem Kraftfahrzeug nach einem Fertigungsvorgang**
Functional testing device for an electronically controlled regulation system in a motor vehicle after a production process
Dispositif d'essai de fonctionnement d'un système de réglage à commande électronique dans un véhicule automobile après un processus de production

(30) Priorität: 27.05.1997 DE 19722188
(43) Veröffentlichungstag der Anmeldung: 02.12.1998
(73) Patentinhaber: Bayerische Motoren Werke Aktiengesellschaft, 80788 München (DE)
(72) Erfinder: Huber, Gerd, 80935 München (DE); Bauer, Werner, 81549 München (DE); Haas, Anton, 81673 München (DE)

(56) Entgegenhaltungen:
- EP-A- 0 221 383
- EP-A- 0 718 614
- DE-U- 29 616 803
- PATENT ABSTRACTS OF JAPAN vol. 011, no. 302 (M-629), 2. Oktober 1987 & JP 62 094443 A (NISSAN MOTOR CO LTD), 30. April 1987

## Beschreibung

Die Erfindung bezieht sich auf eine Vorrichtung zur Funktionsüberprüfung eines elektronisch gesteuerten Regelsystems in einem Kraftfahrzeug nach einem Fertigungsvorgang des Kraftfahrzeugs in einem Produktionswerk.

Es ist bekannt, ein Kraftfahrzeug in einem Produktionswerk nach einzelnen Fertigungsvorgängen oder am Bandende, d. h. nach Durchlaufen sämtlicher Fertigungsvorgänge, zumindest teilweise in Betrieb zu nehmen. Hierbei werden im Stillstand des Kraftfahrzeugs insbesondere die Brennkraftmaschine gestartet, die Funktionsfähigkeit sämtlicher Lampen überprüft, sowie andere Bedienelemente betätigt, um die ihnen zugeordneten Funktionen zu testen.

Zum technischen Hintergrund hierzu wird beispielsweise auf die DE 296 16 803 U, die EP 0 221 383 A, die EP 0 718 614 A und das Japanische Patent Abstract JP 62 094443 A hingewiesen.

Zur Funktionsüberprüfung elektronisch gesteuerter Regelsysteme wird zum Teil lediglich sichergestellt, daß keine Fehlermeldungen, die beispielsweise über Alarmlampen oder Diagnosegeräte abrufbar sind, von den den elektronisch gesteuerten Regelsystemen zugeordneten Steuergeräten ausgegeben werden. Eine derartige Funktionsüberprüfung ist jedoch aufgrund der Komplexität der Funktionen, die ein elektronisch gesteuertes Regelsystem wähwährend der Fahrt durchzuführen hat, nicht ausreichend. Daher wird die Funktionsfähigkeit derartiger Regelsysteme derzeit auch mittels separater, fest installierter Prüfstände getestet. Derartige fest installierte Prüfstände sind mit hohen Kosten und großem Platzbedarf verbunden. Darüber hinaus erfordert die Überprüfung jedes einzelnen Regelsystems durch die Fahrt zum Prüfstand, durch die Initialisierung, durch die Systemprüfung und durch die Fahrt vom Prüfstand zurück eine beachtliche Prüfzeit. Weiterhin ist die Integration neuer Umfänge in die bestehende Prüflandschaft aufgrund von Änderungen in den Regelsystemen mit erheblichen baulichen Maßnahmen verbunden.

Es ist daher Aufgabe der Erfindung, eine Vorrichtung zur Funktionsüberprüfung elektronisch gesteuerter Regelsysteme in Kraftfahrzeugen eingangs genannter Art trotz Sicherstellung einer ausreichenden Überprüfung der Funktionsfähigkeit zu vereinfachen.

Diese Aufgabe wird durch die kennzeichnenden Merkmale des Patentanspruchs 1 gelöst.

Erfindungsgemäß wird für die Dauer eines definierten Fahrzeugbetriebs während einer im Produktionswerk zurückzulegenden Strecke das zu überprüfende elektronisch gesteuerte Regelsystem nach seinem Einbau in das Kraftfahrzeug in Betrieb genommen. Hierbei kann das Fahrzeug tatsächlich in realistischer Weise gestartet und gefahren werden (Fahrzeugbetrieb gleich Fahrbetrieb) oder auch geschleppt oder in einem Transportband definiert bewegt werden. Während des Fahr- bzw. Fahrzeugbetriebs werden die Daten dieses Regelsystems in einem Prüfsystem erfaßt und abgespeichert. Der definierte Fahrzeugbetrieb kann beispielsweise während einer im Produktionswerk ohnehin zurückzulegenden Strecke vorgenommen werden. Für den definierten Fahrzeugbetrieb werden beispielsweise bestimmte Fahrparameter, wie Streckenabschnitte, Kurvenradien, Temperaturen usw., und/oder Bedienvorschriften, wie z. B. schnelles Durchtreten des Gaspedals, Betätigen der Bremse, Lenkbewegungen, Gangschaltungen usw., vorgegeben. Dieser definierte Fahrzeugbetrieb wird für alle Fahrzeuge gleich vorgegeben, so daß die erfaßten und abgespeicherten Daten der einzelnen Regelsysteme unterschiedlicher Fahrzeuge vergleichbar sind. Die Auswertung dieser Daten kann an beliebiger geeigneter Stelle, z. B. an einem Prüfabschlußrechner, erfolgen. Dies bedeutet, daß die Auswertung der erfaßten und abgespeicherten Daten parallel zu weiteren Fertigungsvorgängen auch erst nach dem definierten Fahrzeugbetrieb während der zurückzulegenden Strecke aus Gründen der Zeitersparnis vorgenommen werden kann.

Vorteilhafte Weiterbildungen der Erfindung sind die Gegenstände der Unteransprüche 2 und 3. Demnach kann das Prüfsystem zur Erfassung und Speicherung der Daten des Regelsystems mit dem zu überprüfenden Regelsystem kraftfahrzeugseitig verbindbar sein, d. h. sich während der Meßfahrt im Fahrzeug befinden, oder außerhalb des Kraftfahrzeugs angeordnet sein und dabei während der Meßfahrt mit dem zu überprüfenden Regelsystem drahtlos kommunizieren.

Durch diese erfindungsgemäße Funktionsüberprüfung werden zum einen separate Prüfstände eingespart und zum anderen durch einen definierbaren Fahrzeugbetrieb an die Realität angenäherte Betriebszustände erzeugt, während die elektronisch gesteuerten Regelsysteme aktiviert werden.

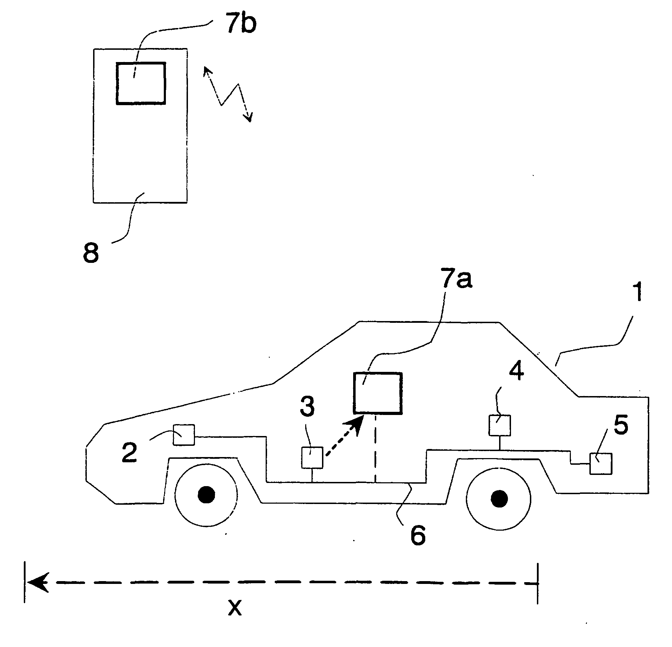

In der Zeichnung ist ein Ausführungsbeispiel der Erfindung dargestellt. Sie zeigt eine erfindungsgemäße Vorrichtung zur Funktionsüberprüfung eines elektronisch gesteuerten Regelsystems in einem Kraftfahrzeug mittels eines Prüfgeräts, das sich während der Meßfahrt im Kraftfahrzeug befindet oder das alternativ während der Meßfahrt von außerhalb des Kraftfahrzeugs drahtlos mit dem zu überprüfenden Regelsystem kommuniziert.

In der Zeichnung sind in einem Kraftfahrzeug 1 mehrere elektronisch gesteuerte Regelsysteme verbaut. Diesen elektronisch gesteuerten Regelsystemen sind jeweils ein Steuergerät 2 bis 5 zugeordnet, die untereinander mittels eines Datenbusses 6, z. B. eines CAN-Busses, verbunden sind. Das Fahrzeug 1 befindet sich in einem Produktionswerk am Ende sämtlicher Fertigungsvorgänge des Kraftfahrzeugs und hat im Produktionswerk noch eine Strecke x zurückzulegen. Während dieser im Produktionswerk zurückzulegenden Strecke x nimmt z. B. ein Fahrer oder eine automatische Transportvorrichtung das Kraftfahrzeug 1 in Betrieb. Hierbei wird ein definierter Fahrbetrieb bzw. Fahrzeugbetrieb vorgegeben. Beispielsweise werden Fahrparameter, wie kick-down, Vollbremsung oder schnelle Lenkbewegungen, für eine vorgegebene Teilstrecke vorgeschrieben. Der definierte Fahrzeugbetrieb wird in der Weise vorgegeben, daß das zu überprüfende elektronisch gesteuerte Regelsystem, z. B. das dem Steuergerät 3 zugeordnete Regelsystem, aktiviert wird. Ist beispielsweise das dem Steuergerät 3 zugeordnete elektronisch gesteuerte Regelsystem ein Automatikgetriebe, wird der definierte Fahrzeugbetrieb vorzugsweise derart vorgegeben, daß während der zurückzulegenden Strecke x Schaltvorgänge ausgeführt werden müssen. Ist dagegen ein elektronisch gesteuertes Regelsystem zur automatischen Dämpferregelung vorgesehen, wird vorzugsweise der definierte Fahrzeugbetrieb so vorgegeben, daß ein Ein- und Ausfedern der Karosserie gegenüber den Rädern provoziert wird.

Die durch den definierten Fahrzeugbetrieb aktivierten Regelsysteme bzw. deren Steuergeräte geben über den Datenbus 6 Daten aus, die über ein Prüfsystem 7a oder 7b erfaßt und abgespeichert werden können. Hierzu ist das Prüfsystem 7a beispielsweise während der Meßfahrt im Kraftfahrzeug vorhanden und entweder direkt an dem Steuergerät eines zu überprüfenden Regelsystems anschließbar oder indirekt über den Datenbus 6 mit diesem Steuergerät verbindbar. Alternativ hierzu ist ein Prüfsystem 7b zur Erfassung und Abspeicherung der Daten des zu überprüfenden aktivierten Regelsystems außerhalb des Kraftfahrzeugs, beispielsweise in einem Standsystem 8 angeordnet und kommuniziert, beispielsweise über Funk, drahtlos mit dem jeweils zu überprüfenden Regelsystem. Die Kommunikation zwischen den Prüfsystemen 7a oder 7b und einem definierten Regelsystem bzw. dessen Steuergerät wird beispielsweise über den elektronisch gesteuerten Regelsystemen zugeordneten Identifizierungscodes vorgenommen. Die gemessenen Daten können z. B. in einem mathematischen Fahrzeugmodell verarbeitet werden, um beispielsweise Abweichungen von einzelnen Sensoren voneinander zu erkennen. Eine statistische Bewertung aller Fahrzeug-Messungen ermöglicht eine frühzeitige Erkennung von Fehlertrends und erlaubt eine engere Auslegung der Prüfspezifikationen.

Durch dieses erfindungsgemäße Ausführungsbeispiel wird deutlich, daß die Notwendigkeit separater Prüfstände entfällt. Durch den Meßbetrieb während einer im Produktionswerk ohnehin zurückzulegenden Strecke erfordert eine Funktionsüberprüfung keinen zusätzlichen Zeitaufwand. Darüber hinaus wird die Prüfung der Funktionsfähigkeit im realistischen Fahrzeugbetrieb und nicht durch synthetisch simulierte Signale durchgeführt. Ergänzend wird darauf hingewiesen, daß das Verfahren zur erfindungsgemäßen Funktionsüberprüfung nicht nur in Produktionswerken sondern auch beim Kundendienst und in den Werkstätten angewendet werden kann.

## Patentansprüche

1. Verfahren zur Funktionsüberprüfung eines elektronisch gesteuerten Regelsystems in einem Kraftfahrzeug nach einem Fertigungsvorgang des Kraftfahrzeugs in einem Produktionswerk, **dadurch gekennzeichnet, dass** für die Dauer eines definierten Fahrzeugbetriebs während einer im Produktionswerk zurückzulegenden Strecke (x) das zu überprüfende elektronisch gesteuerte Regelsystem (2, 3, 4, 5) nach seinem Einbau in das Kraftfahrzeug (1) in Betrieb genommen wird, wobei der definierte Fahrzeugbetrieb in der Weise vorgegeben wird, **dass** das zu überprüfende elektronisch gesteuerte Regelsystem aktiviert wird, und **dass** Daten dieses Regelsystems in einem Prüfsystem (7a; 7b) erfasst und abgespeichert werden.

2. Verfahren nach Patentanspruch 1, **dadurch gekennzeichnet, dass** das Prüfsystem (7a) mit dem zu überprüfenden Regelsystem (2, 3, 4, 5) kraftfahrzeugseitig verbindbar ist.

3. Verfahren nach Patentanspruch 1, **dadurch gekennzeichnet, dass** das Prüfsystem (7b) außerhalb des Kraftfahrzeugs angeordnet ist und mit dem zu überprüfenden Regelsystem (2, 3, 4, 5) drahtlos kommuniziert.

## Claims

1. A method for the functional checking of an electronically controlled regulating system in a motor vehicle after a manufacturing process of the motor vehicle in a production works, **characterised in that**, for the duration of a defined vehicle operation for a distance (x) to be covered in the production works, the electronically controlled regulating system (2, 3, 4, 5) to be checked is put into operation after its installation in the motor vehicle (1), the defined vehicle operation being specified in such a way that the electronically controlled regulating system to be checked is activated, and **in that** data of this regulating system is collected in a testing system (7a; 7b) and stored.

2. A method according to claim 1, **characterised in that** the testing system (7a) can be connected to the regulating system (2, 3, 4, 5) to be checked, on the vehicle side.

3. A method according to claim 1, **characterised in that** the testing system (7b) is arranged outside the motor vehicle and communicates wirelessly with the regulating system (2, 3, 4, 5) to be checked.

## Revendications

1. Procédé de contrôle des fonctions d'un système de régulation à commande électronique dans un véhicule automobile après son processus de fabrication dans une usine de production,
**caractérisé en ce que**,
pendant la durée d'un fonctionnement défini du véhicule dans une chaîne de production (x) à accomplir dans l'usine de production, le système de régulation (2, 3, 4, 5) à commande électronique qui doit être testé est mis en service une fois monté dans le véhicule automobile (1), le fonctionnement défini du véhicule étant prédéterminé de telle sorte que le système de régulation à commande électronique qui doit être testé soit activé et que les données de ce système de régulation soient saisies et enregistrées dans un système de test (7a ; 7b).

2. Procédé selon la revendication 1,
**caractérisé en ce que**
le système de test (7a) peut être relié côté véhicule automobile au système de régulation (2, 3, 4, 5) à tester.

3. Procédé selon la revendication 1,
**caractérisé en ce que**
le système de test (7b) est disposé à l'extérieur du véhicule automobile et communique sans fil avec le système de régulation (2, 3,4, 5) à tester.
